Europäisches Patentamt

European Patent Office

Office européen des brevets

(19)

(11) Veröffentlichungsnummer : **0 169 915**
**B1**

(12) # EUROPÄISCHE PATENTSCHRIFT

(45) Veröffentlichungstag der Patentschrift :
07.09.88

(21) Anmeldenummer : 84106475.1

(22) Anmeldetag : 06.06.84

(51) Int. Cl.⁴ : **H 03 D   3/00, G 06 F   7/548**

(54) **Digitaler Phasendemodulator.**

(43) Veröffentlichungstag der Anmeldung :
05.02.86 Patentblatt 86/06

(45) Bekanntmachung des Hinweises auf die Patenterteilung : 07.09.88 Patentblatt 88/36

(84) Benannte Vertragsstaaten :
**DE FR NL**

(56) Entgegenhaltungen :
**EP-A- 0 074 858**
**US-A- 4 090 145**

(73) Patentinhaber : **Deutsche ITT Industries GmbH**
**Hans-Bunte-Strasse 19 Postfach 840**
**D-7800 Freiburg (DE)**

(72) Erfinder : **Mehrgardt, Sönke, Dr.**
**Häglestrasse 26**
**D-7801 March-Neuershausen (DE)**

(74) Vertreter : **Morstadt, Volker, Dipl.-Ing.**
**c/o Deutsche ITT Industries GmbH Patent/Lizenzab-**
**teilung Postfach 840 Hans-Bunte-Strasse 19**
**D-7800 Freiburg/Brsg. (DE)**

Jouve, 18, rue St-Denis, 75001 Paris, France

## Beschreibung

Die Erfindung betrifft einen digitalen Phasendemodulator mit einem von einem Taktsignal getakteten Analog-Digital-Wandler für die Umwandlung des zu demodulierenden Analogsignals in ein Digitalsignal, mit einem digitalen 90°-Phasenschieber ( = Hilbert-Transformator = Quadratursignal- Generator), dem das Digitalsignal zur Bildung des Quadratursignals zugeführt ist, mit einer Konditionierschaltung für Digital- und Quadratursignal, an deren Ausgang entsprechende, zum ersten x'-y'-Koordinatensystem-Halbquadranten gehörende digitale Quadrantsignale x', y' entstehen, und mit einer die Arcus-Tangens-Funktion des Quotienten y'/x' liefernden, einen Festwertspeicher enthaltenden Schaltung, vgl. den jeweiligen Oberbegriff der Ansprüche 1 und 2. Eine derartige Anordnung ist, was das Prinzip betrifft, in der US-A-4 090 145 beschrieben.

Der benötigte Speicherplatz des Festwertspeichers hängt bei der vorbeschriebenen Anordnung vom vorgesehenen Auflösungsvermögen des Analog-Digital-Wandlers, d. h. von der Stellenzahl n der zu verarbeitenden Digitalsignale ab ; es werden nämlich $2^n \cdot n$ Speicherplätze (Bit) benötigt.

Für die digitale Signalverarbeitung von Videosignalen mit n = 6...8 Stellen sind also $2^7$ bis $2^9$ Speicherplätze des Festwertspeichers erforderlich, welche Forderung mit den heutigen Mitteln der Halbleitertechnik ohne weiteres erfüllt werden kann. Digitalsignale mit größeren Stellenzahlen, z. B. n = 13...17, wie sie z. B. für die digitale Signalverarbeitung von Audiosignalen erwünscht sind, führen jedoch zu einem Speicherplatzbedarf von $2^{14}...2^{18}$ Bit, was mit den heutigen Mitteln der Halbleitertechnik nur zu einer unrealistischen, d. h. mit vertretbarem Aufwand nicht realisierbaren Halbleiterkörper-Größe einer den digitalen Phasendemodulator enthaltenden integrierten Schaltung führt. Der in den Ansprüchen gekennzeichneten Erfindung liegt somit die Aufgabe zugrunde, ausgehend von dem eingangs genannten Stand der Technik, einen digitalen Phasendemodulator anzugeben, der Digitalsignale mit einer Stellenanzahl insles. größer 10 ohne den geschilderten großen Speicherplatzbedarf des Festwertspeichers zu demodulieren gestattet.

Der wesentliche Vorteil der Erfindung ist darin zu sehen, daß bei der einen Lösungsvarianten wie sie im Anspruch 1 angegeben ist, nur noch $n^2$ Speicherplätze, zudem verteilt auf n kleine Festwertspeicher, benötigt werden und daß sich dieser Speicherplatzbedarf bei der zweiten Lösungsvariante, wie sie im Anspruch 2 angegeben ist, nochmals auf ein Viertel bis die Hälfte reduziert.

Die Erfindung und weitere Vorteile werden nun anhand der Figuren der Zeichnung näher erläutert.

Fig. 1 zeigt schematisch in Form eines Blockschaltbilds ein Ausführungsbeispiel der ersten Lösungsvariante der Erfindung, und

Fig. 2 zeigt in gleicher Weise das Schaltbild eines Ausführungsbeispiels der zweiten Lösungsvariante der Erfindung.

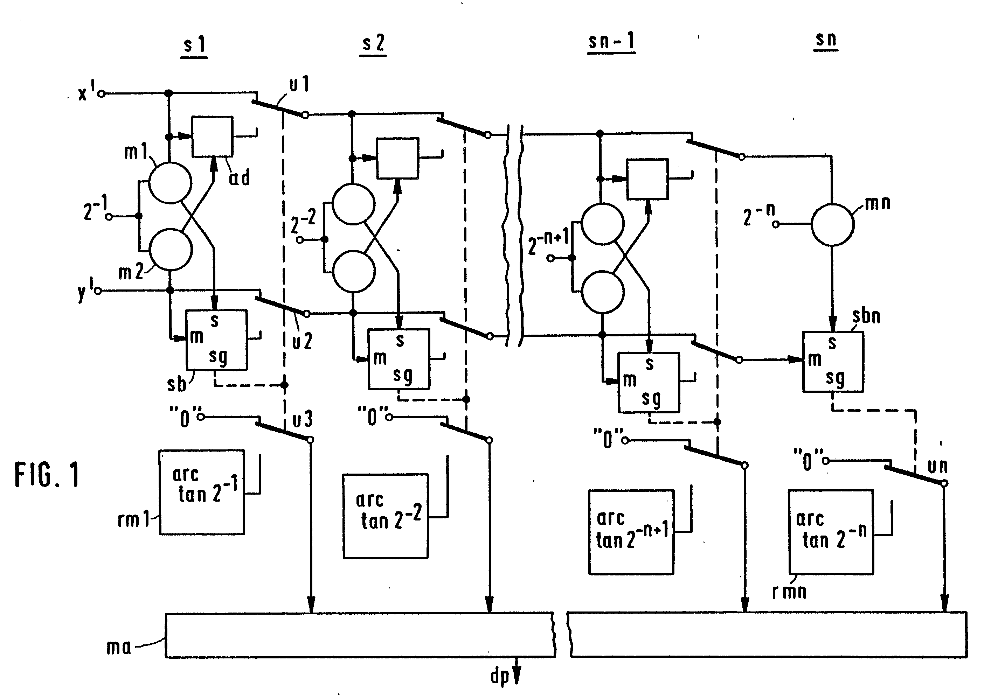

Die in Form eines schematischen Blockschaltbilds aufgebaute Fig. 1 zeigt ein Ausführungsbeispiel der ersten Lösungsvariante der Erfindung. Als Eingangssignale dienen die oben erwähnten, entsprechend konditionierten Quadrantsignale x', y' die beispielsweise entsprechend der in der eingangs genannten US-Patentschrift angegebenen Anordnung erzeugt werden können. Die Erzeugung des dem Quotienten y'/x' entsprechenden Arcus-Tangens-Signals also des Winkels zwischen der Abszisse und dem von x', y' gebildeten Vektor im x'-y'-Koordinatensystem, erfaßt somit dessen ersten Halbquadranten, also Winkel zwischen 0 und 45°. Aufgrund der Periodizität der Tangensfunktion können mittels der vorbeschriebenen Konditionierschaltung auch die entsprechenden Ausgangssignale dp für größere Winkel als 45° erzeugt werden.

Die erste Lösungsvariante nach Fig. 1 besteht aus n-1 gleichartigen Stufen s1, s2, sn-1 sowie der n-ten Stufe sn, deren Aufbau von denen der anderen Stufen geringfügig abweicht. Mit n ist die maximale Anzahl der vorgegebenen Stellen eines der Quadrantsignale x', y' bezeichnet. Von den gleichartigen Stufen s1...sn-1 besteht jede aus dem Addierer ad, dem Subtrahierer sb, dem ersten und dem zweiten Konstantenmultiplizierer m1, m2 für den Faktor $2^{-r}$, wobei r gleich 1...n-1 ist, aus dem ersten, dem zweiten und dem dritten elektronischen Umschalter u1, u2, u3 sowie dem Festwertspeicher rm1 für arctan $2^{-r}$, d. h. es ist lediglich für den alleinigen Arcus-Tangens-Wert $2^{-r}$ in jeder Stufe ein entsprechend wenig Halbleiterkörperfläche erfordernder Festwertspeicher vorzusehen.

In der ersten Stufe s1 ist das Quadrantsignal x' bzw. in jeder weiteren Stufe s2...sn-1 der Ausgang des zur vorangehenden Stufe gehörenden ersten Umschalters u1 am jeweiligen ersten Eingang des Addierers ad, des ersten Konstantenmultiplizierers m1 und des ersten Umschalters u1 dieser Stufe angeschlossen.

In der ersten Stufe s1 liegt das zweite Quadrantsignal y' bzw. in jeder weiteren Stufe s2...sn-1 der Ausgang des zur vorangehenden Stufe gehörenden zweiten Umschalters u2 am Eingang des zweiten Konstantenmultiplizierers m2 dieser Stufe und am ersten Eingang des zweiten Umschalters u2 sowie am Minuendeingang m des Subtrahierers sb. Der Ausgang des zweiten Konstantenmultiplizierers m2 ist mit dem zweiten Eingang des Addierers ad und der Ausgang des ersten Konstantenmultiplizierers m1 mit dem Subtrahendeingang s des Subtrahierers sb verbunden. Der Ausgang des Addierers ad liegt am zweiten Eingang des ersten Umschalters u1 und der Ausgang des Subtrahierers sb am zweiten Eingang des zweiten Umschalters u2, während der erste Eingang des dritten Umschalters u3 an der Zahl Null « 0 » und sein zweiter Eingang am Ausgang des Festwertspeichers rm1 sowie sein Ausgang an einem der n Eingänge des Mehrfachaddierers ma angeschlossen ist. Der Vorzeichenausgang sg des Subtrahierers sb liegt in jeder Stufe am jeweiligen Steuereingang der drei Umschalter u1, u2, u3, und die Schaltzuordnung ist so gewählt, daß bei negativem Vorzeichen der jeweilige erste Eingang und bei positivem Vorzeichen der jeweilige zweite Eingang zum jeweiligen Ausgang durchgeschaltet ist.

Die n-te Stufe sn besteht aus dem weiteren Konstantenmultiplizierer mn für den Faktor $2^{-n}$, dessen Eingang am Ausgang des ersten Umschalters u1 der (n-1)-ten Stufe sn-1 liegt, aus dem weiteren Subtrahierer sbn, dessen Minuendeingang m am Ausgang des zweiten Umschalters u2 der vorausgehenden Stufe sn-1 und dessen Subtrahend-Eingang s am Ausgang des weiteren Konstantenmultiplizierers mn liegt, ferner aus dem weiteren Umschalter un, dessen erstem Eingang die Zahl Null « 0 » zugeführt ist, und schließlich aus dem Festwertspeicher rmn für arctan $2^{-n}$, dessen Ausgang mit dem zweiten Eingang des weiteren Umschalters un verbunden ist, dessen Ausgang hinwiederum am Mehrfachaddierer ma und dessen Steuereingang am Vorzeichenausgang sg des weiteren Subtrahierers sbn angeschlossen ist.

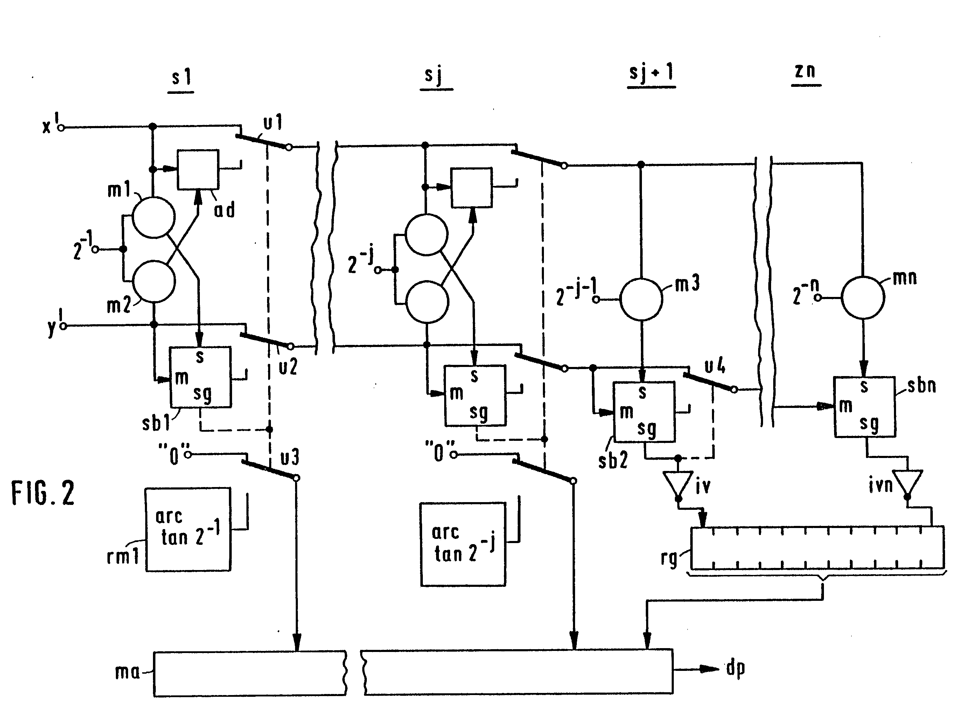

Die zweite Lösungsvariante nach Fig. 2 unterscheidet sich von der ersten nach Fig. 1 im wesentlichen darin, daß ab einer Stufe j + 1, wobei j eine ganze Zahl zwischen 4 und 8 sein kann, der Festwertspeicher rm1 nach Fig. 1 weggelassen ist, da für Argumente $2^{-j}$ der zugehörige Tangenswert durch das Argument selbst mit ausreichender Genauigkeit ersetzt werden kann. Die ersten j Stufen der Anordnung nach Fig. 2 sind daher identisch aufgebaut wie die entsprechenden Stufen s1...sn-1 der Anordnung nach Fig. 1, wobei lediglich der Subtrahierer sb nach Fig. 1 nunmehr als erster Subtrahierer sb1 nach Fig. 2 definiert ist.

Anstatt der n-j-1 gleichartigen Stufen nach Fig. 1 enthält die zweite Lösungsvariante nach Fig. 2 n-j-1 gleichartige Zellen und anstatt der n-ten Stufe nach Fig. 1 die (n-j)-te Zelle zn. Ferner ist das (n-j)-stufige Register rg vorgesehen, dessen Parallelausgang zu einem der Eingänge des Mehrfachaddierers ma führt. Dieser hat also gegenüber der Anordnung nach Fig. 1, wonach er n Eingänge hat und somit n-1 Additionen auszuführen hat, nur noch j+l Eingänge für j Additionen und ist somit von geringerem Halbleiterkörper-Platzbedarf als in Fig. 1.

Die gleichartigen Zellen, von der in Fig. 2 die Zelle sj+1 gezeigt ist, bestehen jeweils aus dem dritten Konstantenmultiplizierer m3 für den Faktor $2^{-r}$, dessen Eingang am Ausgang des ersten Umschalters u1 der j-ten Stufe sj liegt ; ferner aus dem vierten Umschalter u4, dessen erster Eingang in der (j + 1) ten Zelle am Ausgang des zweiten Umschalters u2 der j-ten Stufe sj bzw. in jeder weiteren Zelle am Ausgang des vierten Umschalters u4 der vorangehenden Zelle liegt ; ferner aus dem zweiten Subtrahierer sb2, dessen Minuendeingang m am ersten Eingang des vierten Umschalters u4, dessen Subtrahendeingang s am Ausgang des dritten Konstantenmultiplizierers m3, dessen Ausgang am zweiten Eingang des vierten Umschalters u4 und dessen Vorzeichenausgang sg am Steuereingang des vierten Umschalters u4 liegt ; und schließlich aus dem Inverter iv, dessen Eingang mit dem Vorzeichenausgang sg des vierten Umschalters u4 verbunden ist. r' ist dabei gleich j + 1...n-1.

Auch bei dieser Lösungsvariante ist wie bei der nach Fig. 1 die Schaltzuordnung so gewählt, daß bei negativem Vorzeichen am Vorzeichenausgang sg der beiden Subtrahierer sb1, sb2 der jeweilige erste Eingang bzw. bei positivem Vorzeichen der jeweilige zweite Eingang der zugeordneten Umschalter u1, u2, u3 (in den Stufen s1...sj) bzw. u4 (in den Zellen) zum jeweiligen Ausgang durchgeschaltet ist.

Die (n-j)-te Zelle zn besteht aus dem weiteren Konstantenmultiplizierer mn für den Faktor $2^{-n}$, dessen Eingang am Ausgang des ersten Umschalters u1 der j-ten Stufe sj liegt ; ferner aus dem weiteren Subtrahierer sbn, dessen Minuendeingang m am Ausgang des vierten Umschalters u4 der vorausgehenden Zelle und dessen Subtrahendeingang s am Ausgang des weiteren Konstantenmultiplizierers mn liegt ; und schließlich aus dem weiteren mit seinem Eingang am Vorzeichenausgang sg des weiteren Subtrahierers sbn liegenden Inverter ivn.

Der jeweilige Ausgang aller Inverter iv, ivn liegt entsprechend seiner Wertigkeit am zugehörigen Stufeneingang des Registers rg und dessen Parallelausgang an einem der Eingänge des Mehrfachaddierers ma, an dessen Ausgang wiederum das digitale phasendemodulierte Signal dp auftritt, das im ersten Halbquadranten des x'-y'-Koordinatensystems, also zwischen 0° und 45° liegt.

In den Figuren der Zeichnung sind unabhängig von der schaltungstechnischen Realisierung die Verbindungsleitungen lediglich als einfache Leitungen gezeichnet. Dies soll jedoch keine Einschränkung dahingehend bedeuten, daß auch eine parallele Signalverarbeitung der Quadrantsignale x', y' vorgenommen wird. In einem solchen Fall sind die Verbindungsleitungen dann die üblichen Busse, deren Anzahl an parallelen Leitungen der Stellenzahl n der zu verarbeitenden Digitalworte angepaßt ist. In diesem Fall sind dann auch die entsprechenden Addierer, Subtrahierer, Multiplizierer und Umschalter entsprechende Parallelverarbeitungseinheiten. Eine derartige Realisierung wird man im übrigen dann vorsehen, wenn schnelle Signalverarbeitung erforderlich ist, wobei dann die Gesamtanordnung mittels der sogenannten Pipeline-Technik vorgenommen ist.

Kommt es andererseits nicht so sehr auf schnelle Signalverarbeitung an, so können die beiden Lösungsvarianten der Erfindung auch durch Anwendung der Multiplextechnik vereinfacht werden, d. h. die Gesamtstufen- bzw. Zellenanzahl ist kleiner als der Stellenzahl n der Quadrantsignale x', y' entspricht, und die Zellen werden während eines Bearbeitungszyklus mehrfach durchlaufen.

Die beiden Lösungsvarianten der Erfindung gehen von der Überlegung aus, daß mittels der beiden Substitutionen $u = y' - bx'$ ; $v = x' + by'$ der Phasenwinkel dp durch die Beziehung angegeben werden kann dp = arctan u/v + arctan b, wobei b bei Realisierung der Erfindung mittels Binärschaltungen gleich $2^{-r}$ ist. Der Erfindung liegt ferner die rekursive Anwendung der letztgenannten Beziehung zugrunde.

Die Erfindung ist zur Realisierung als integrierte Schaltung geeignet, insbesondere in Form der sogenannten MOS-Schaltungen, also als Isolierschicht-Feldeffekttransistor-Schaltung. Als spezielle Anwendungsgebiete der Erfindung im Audiobereich sind die Demodulation beim in den USA genormten Rundfunk-Stereo-System (amplitudenmoduliertes System), die Fernsehton-Demodulation und die UKW-Rundfunk-Demodulation zu erwähnen. Ferner kann die Erfindung auch bei der SECAM-Chrominanz-Demodulation und bei der magnetischen Bildaufzeichnung, z. B. in Videorecordern, angewendet werden.

## Patentansprüche

1. Digitaler Phasendemodulator
— mit einem von einem Taktsignal getakteten Analog-Digital-Wandler für die Umwandlung des zu demodulierenden Analogsignals in ein Digitalsignal,
— mit einem digitalen 90°-Phasenschieber, dem das Digitalsignal zur Bildung des Quadratursignals zugeführt ist,
— mit einer Konditionierschaltung für Digital- und Quadratursignal, an deren Ausgang entsprechende zum ersten Halbquadranten des x'-y'-Koordinatensystems gehörende Quadrantsignale x', y' entstehen, und
— mit einer die Arcus-Tangens-Funktion des Quotienten y'/x' liefernden, einen Festwertspeicher enthaltenden Schaltung,
gekennzeichnet durch folgende Merkmale :
— die Schaltung besteht aus einem Mehrfachaddierer (ma), aus einer n-ten Stufe (sn) und aus n-1 gleichartigen Stufen (s1...sn-1), wobei n = maximale Anzahl der vorgegebenen Stellen eines der Quadrantsignale (x', y') ist, die jeweils aus
— einem Addierer (ad), einem Subtrahierer (sb), einem ersten und einem zweiten Konstantenmultiplizierer (m1, m2) für den Faktor $2^{-r}$, wobei r = 1...n-1 ist, einem ersten, einem zweiten und einem dritten elektronischen Umschalter (u1, u2, u3) sowie einem Festwertspeicher (rm1) für arctan $2^{-r}$ bestehen und bei denen
— in der ersten Stufe (s1) das erste Quadrantsignal (x') bzw. in jeder weiteren Stufe (s2...sn-1) der Ausgang des zur vorangehenden Stufe gehörenden ersten Umschalters (u1) am jeweiligen ersten Eingang des Addierers (ad), des ersten Konstantenmultiplizierers (m1) und des ersten Umschalters (u1) dieser Stufe,
— in der ersten Stufe (s1) das zweite Quadrantsignal (y') bzw. in jeder weiteren Stufe (s2...sn-1) der Ausgang des zur vorangehenden Stufe gehörenden zweiten Umschalters (u2) am Eingang des zweiten Konstantenmultiplizierers (m2) dieser Stufe und am ersten Eingang des zweiten Umschalters (u2) sowie am Minuendeingang (m) des Subtrahierers (sb),
— der Ausgang des zweiten Konstantenmultiplizierers (m2) am zweiten Eingang des Addierers (ad) und der Ausgang des ersten Konstantenmultiplizierers (m1) am Subtrahendeingang (s) des Subtrahierers (sb),
— der Ausgang des Addierers (ad) am zweiten Eingang des ersten Umschalters (u1) und der Ausgang des Subtrahierers (sb) am zweiten Eingang des zweiten Umschalters (u2),
— der erste Eingang des dritten Umschalters (u3) an der Zahl Null (« 0 ») und sein zweiter Eingang am Ausgang des Festwertspeichers (rm1) sowie sein Ausgang an einem der n Eingängen des Mehrfachaddierers (ma) und
— der Vorzeichenausgang (sg) des Subtrahierers (sb) am jeweiligen Steuereingang der drei Umschalter (u1, u2, u3) liegt und die Schaltzuordnung so gewählt ist, daß bei negativem Vorzeichen der jeweilige erste Eingang und bei positivem Vorzeichen der jeweilige zweite Eingang zum jeweiligen Ausgang durchgeschaltet ist,
— die n-te Stufe (sn) besteht aus einem weiteren Konstantenmultiplizierer (mn) für den Faktor $2^{-n}$, dessen Eingang am Ausgang des ersten Umschalters (u1) der (n-1)-ten Stufe (sn-1) liegt, aus einem weiteren Subtrahierer (sbn), dessen Minuendeingang (m) am Ausgang des zweiten Umschalters (u2) der (n-1) ten Stufe (sn-1) und dessen Subtrahendeingang (s) am Ausgang des weiteren Konstantenmultiplizierers (mn) liegt, aus einem weiteren Umschalter (un), dessen erstem Eingang die Zahl Null (« 0 ») zugeführt ist, und aus einem Festwertspeicher (rmn) für arctan $2^{-n}$, dessen Ausgang mit dem zweiten Eingang des weiteren Umschalters (un) verbunden ist, dessen Ausgang am Mehrfachaddierer (ma) und dessen Steuereingang am Vorzeichenausgang (sg) des weiteren Subtrahierers (sbn) liegt, und
— am Ausgang des Mehrfachaddierers (ma) ist das digitale phasendemodulierte Signal (dp) des ersten Koordinatensystem-Halbquadranten abzunehmen.

2. Digitaler Phasendemodulator
— mit einem von einem Taktsignal getakteten Analog-Digital-Wandler für die Umwandlung des zu demodulierenden Analogsignals in ein Digitalsignal,
— mit einem digitalen 90°-Phasenschieber, dem das Digitalsignal zur Bildung des Quadratursignals zugeführt ist,
— mit einer Konditionierschaltung für Digital- und Quadratursignal, an deren Ausgang entsprechende zum ersten Halbquadranten des x'-y'-Koordinatensystems gehörende Quadrantsignale x', y' entstehen, und
— mit einer die Arcus-Tangens-Funktion des Quotienten y'/x' liefernden, einen Festwertspeicher enthaltenden Schaltung, gekennzeichnet durch folgende Merkmale :
— die Schaltung besteht aus einem Mehrfachaddierer (ma), einem (n-j) stufigen Register (rg), aus n-j-1 gleichartigen Zellen (sj + 1), aus einer (n-3)-ten Zelle (zn) und aus j gleichartigen Stufen (s1...sj), wobei n = maximale Anzahl der vorgegebenen Stellen eines der Quadrantsignale (x', y') und j = eine der Zahlen zwischen 4 und 8 ist, die jeweils aus

— einem Addierer (ad), einem ersten Subtrahierer (sb1), einem ersten und einem zweiten Konstantenmultiplizierer (m1, m2) für den Faktor $2^{-r}$, wobei r = 1...j ist, einem ersten, einem zweiten und einem dritten elektronischen Umschalter (u1, u2, u3) sowie einem Festwertspeicher (rm1) für arctan $2^{-r}$ bestehen und bei denen

— in der ersten Stufe (s1) das erste Quadrantsignal (x') bzw. in jeder weiteren Stufe (s2...sj) der Ausgang des zur vorangehenden Stufe gehörenden ersten Umschalters (u1) am jeweiligen ersten Eingang des Addierers (ad), des ersten Konstantenmultiplizierers (m1) und des ersten Umschalters (u1) dieser Stufe,

— in der ersten Stufe (s1) das zweite Quadrantsignal (y') bzw. in jeder weiteren Stufe (s2...sj) der Ausgang des zur vorangehenden Stufe gehörenden zweiten Umschalters (u2) am Eingang des zweiten Konstantenmultiplizierers (m2) dieser Stufe und am ersten Eingang des zweiten Umschalters (u2) sowie am Minuendeingang (m) des Subtrahierers (sb),

— der Ausgang des zweiten Konstantenmultiplizierers (m2) am zweiten Eingang des Addierers (ad) und der Ausgang des ersten Konstantenmultiplizierers (m1) am Subtrahendeingang (s) des ersten Subtrahierers (sb1),

— der Ausgang des Addierers (ad) am zweiten Eingang des ersten Umschalters (u1) und der Ausgang des ersten Subtrahierers (sb1) am zweiten Eingang des zweiten Umschalters (u2),

— der erste Eingang des dritten Umschalters (u3) an der Zahl Null (« 0 ») und sein zweiter Eingang am Ausgang des Festwertspeichers (rm1) sowie sein Ausgang am einen der j + 1 Eingänge des Mehrfachaddierers (ma) und

— der Vorzeichenausgang (sg) des ersten Subtrahierers (sb1) am jeweiligen Steuereingang der drei Umschalter (u1, u2, u3) liegt,

— die Zellen (sj + 1) bestehen jeweils aus einem dritten Konstantenmultiplizierer (m3) für den Faktor $2^{-r'}$, wobei r' = j + 1...n-1 ist, dessen Eingang am Ausgang des ersten Umschalters (u1) der j-ten Stufe (sj) liegt, aus einem vierten Umschalter (u4), dessen erster Eingang in der (j + 1)-ten Zelle am Ausgang des zweiten Umschalters (u2) der j-ten Stufe (sj) bzw. in jeder weiteren Zelle am Ausgang des vierten Umschalters (u4) der vorausgehenden Zelle liegt, aus einem zweiten Subtrahierer (sb2), dessen Minuendeingang (m) am ersten Eingang des vierten Umschalters (u4), dessen Subtrahendeingang (s) am Ausgang des dritten Konstantenmultiplizierers (m3), dessen Ausgang am zweiten Eingang des vierten Umschalters (u4) und dessen Vorzeichenausgang (sg) am Steuereingang des vierten Umschalters (u4) liegt, und aus einem Inverter (iv), dessen Eingang mit dem Vorzeichenausgang (sg) des vierten Umschalters (u4) verbunden ist,

— bei negativem Vorzeichen am Vorzeichenausgang (sg) der beiden Subtrahierer (sb1, sb2) ist der jeweilige erste Eingang bzw. bei positivem Vorzeichen der jeweilige zweite Eingang der zugeordneten Umschalter (u1, u2, u3 ; u4) zum jeweiligen Ausgang durchgeschaltet,

— die (n-j)-te Zelle (zn) besteht aus einem weiteren Konstantenmultiplizierer (mn) für den Faktor $2^{-n}$, dessen Eingang am Ausgang des ersten Umschalters (u1) der j-ten Stufe (sj) liegt, aus einem weiteren Subtrahierer (sbn), dessen Minuendeingang (m) am Ausgang des vierten Umschalters (u4) der vorausgehenden Zelle und dessen Subtrahendeingang (s) am Ausgang des weiteren Konstantenmultiplizierers (mn) liegt, und aus einem weiteren mit seinem Eingang am Vorzeichenausgang (sg) des weiteren Subtrahierers (sbn) liegenden Inverter (ivn),

— der jeweilige Ausgang aller Inverter (iv, ivn) liegt entsprechend seiner Wertigkeit am zugehörigen Stufeneingang des Registers (rg) und dessen Parallelausgang an einem der Eingänge des Mehrfachaddierers (ma), und

— am Ausgang des Mehrfachaddierers (ma) ist das digitale phasendemodulierte Signal (dp) des ersten Koordinatensystem-Halbquadranten abzunehmen.

## Claims

1. Digital phase detector comprising
— an analog-to-digital converter serving to convert the analog signal to be detected into a digital signal and clocked by a clock signal,
— a digital 90° phase shifter to which the digital signal is applied for forming the quadrature signal,
— a conditioning circuit for the digital and quadrature signals whose output provides corresponding digital quadrant signals (x', y') belonging to the first half-quadrant of the x' - y' coordinate system, and
— a circuit delivering the arc-tan function of the quotient y'/x' and containing a read-only memory,
characterized by the following features :
— The circuit consists of a multiple-input adder (ma), an nth stage (sn), and n-1 like stages (s1...sn-1) (n = maximum number of predetermined bits of one of the quadrant signals (x', y')) each of which consists of
— an adder (ad), a subtracter (sb), first and second constant multipliers (m1, m2) for the factor $2^{-r}$ (where r = 1...n-1), first, second and third electronic changeover switches (u1, u2, u3), and a read-only memory (rm1) for arc tan $2^{-r}$, and in which
— in the first stage (s1), the first quadrant signal (x'), and in each of the other stages (s2...sn-1), the output of the first changeover switch (u1) of the preceding stage are coupled to the first inputs of the adder (ad), the first constant multiplier (m1), and the first changeover switch (u1) ;

— in the first stage (s1), the second quadrant signal (y'), and in each of the other stages (s2...sn-1), the output of the second changeover switch (u2) of the preceding stage are coupled to the first inputs of the second constant multiplier (m2) and the second changeover switch (u2) and to the minuend input (m) of the subtracter (sb) ;

— the output of the second constant multiplier (m2) is coupled to the second input of the adder (ad), and the output of the first constant multiplier (m1) to the subtrahend input (s) of the subtracter (sb) ;

— the output of the adder (ad) is coupled to the second input of the first changeover switch (u1), and the output of the subtracter (sb) to the second input of the second changeover switch (u2) ;

— the first input of the third changeover switch (u3) is presented with the number zero (« 0 »), and the second input of this changeover switch (u3) is connected to the output of the read-only memory (rm1), while its output is coupled to one of the n inputs of the multiple-input adder (ma), and

— the sign output (sg) of the subtracter (sb) is connected to the control inputs of the three changeover switches (u1, u2, u3), and the combinatorial assignment is such that the first input of each of the three changeover switches (u1, u2, u3) is connected to the output of the switch when the sign is negative, while the second input is connected to the output when the sign is positive ;

— the nth stage (sn) consists of an additional constant multiplier (mn) for the factor $2^{-n}$ having its input connected to the output of the first changeover switch (u1) of the (n-1) th stage (sn-1), an additional subtracter (sbn) having its minuend input (m) and its subtrahend input (s) connected to the output of the second changeover switch (u2) of the (n-1) th stage (sn-1) and to the output of the additional constant multiplier (mn), respectively, an additional changeover switch (un) whose first input is presented with the number zero (« 0 »), and a read-only memory (rmn) for arc tan $2^{-n}$ having its output coupled to the second input of the additional changeover switch (un) whose output is coupled to the multiple-input adder (ma), and whose control input is connected to the sign output (sg) of the additional subtracter (sbn), and

— the output of the multiple-input adder (ma) provides the digital phase-detected signal (dp) of the first half-quadrant of the coordinate system.

2. Digital phase detector comprising

— an analog-to-digital converter serving to convert the analog signal to be detected into a digital signal and clocked by a clock signal,

— a digital 90° phase shifter to which the digital signal is applied for forming the quadrature signal,

— a conditioning circuit for the digital and quadrature signals whose output provides corresponding digital quadrant signals (x', y') belonging to the first half-quadrant of the x' - y' coordinate system, and

— a circuit delivering the arc-tan function of the quotient y'/x' and containing a read-only memory,

characterized by the following features :

— The circuit consists of a multiple-input adder (ma), an (n-j)-stage register (rg), n-j-1 like cells (sj + 1), an (n-j) th cell (zn), and j like stages (s1...sj) (where n = maximum number of predetermined bits of one of the quadrant signals (x', y') ; j = one of the numbers between 4 and 8) each of which consists of

— an adder (ad), a first subtracter (sb1), first and second constant multipliers (m1, m2) for the factor $2^{-r}$ (where r = 1...j), first, second, and third electronic changeover switches (u1, u2, u3), and a read-only memory (rm1) for arc tan $2^{-r}$, and in which

— in the first stage (s1) the first quadrant signal (x'), and in each of the other stages (s2...sj), the output of the first changeover switch (u1) of the preceding stage are coupled to the first inputs of the adder (ad), the first constant multiplier (m1), and the first changeover switch (u1) ;

— in the first stage (s1), the second quadrant signal (y'), and in each of the other stages (s2...sj), the output of the second changeover switch (u2) of the preceding stage are coupled to the first inputs of the second constant multiplier (m2) and the second changeover switch (u2) and to the minuend input (m) of the subtracter (sb) ;

— the output of the second constant multiplier (m2) is coupled to the second input of the adder (ad), and the output of the first constant multiplier (m1) to the subtrahend input (s) of the first subtracter (sb1) ;

— the output of the adder (ad) is coupled to the second input of the first changeover switch (u1), and the output of the first subtracter (sb1) to the second input of the second changeover switch (u2) ;

— the first input of the third changeover switch (u3) is presented with the number zero (« 0 »), and the second input of this changeover switch (u3) is connected to the output of the read-only memory (rm1), while its output is coupled to one of the j + 1 inputs of the multiple-input adder (ma), and

— the sign output (sg) of the first subtracter (sb1) is coupled to the control inputs of the three changeover switches (u1, u2, u3) ;

— each of the cells (sj + 1) consists of a third constant multiplier (m3) for the factor $2^{-r'}$ (where r' = j + 1... n-1) having its input connected to the output of the first changeover switch (u1) of the jth stage (sj), a fourth changeover switch (u4) whose first input is connected in the (j + 1) th cell to the output of the second changeover switch (u2) of the jth stage (sj) and in each of the other cells to the output of the fourth changeover switch (u4) of the preceding cell, a second subtracter (sb2) whose minuend input (m) and subtrahend input (s) are connected, respectively, to the first input of the fourth changeover switch (u4) and to the output of the third constant multiplier (m3), and whose output is coupled to the second input of the fourth changeover switch (u4), while its sign output (sg) is coupled to the control input of the fourth changeover switch (u4), and an inverter (iv) having its input connected to the sign output (sg) of the fourth changeover switch (u4) ;

— when the signs at the sign outputs (sg) of the two subtracters (sb1, sb2) are negative, the first inputs of the associated changeover switches (u1, u2, u3 ; u4) are connected to the outputs of the switches, and when the sign is positive, the second inputs of the associated changeover switches are connected to the outputs of the switches ;

— the (n-j) th cell (zn) consists of an additional constant multiplier (mn) for the factor $2^{-n}$ having its input connected to the output of the first changeover switch (u1) of the jth stage (sj), an additional subtracter (sbn) having its minuend input (m) and its subtrahend input connected, respectively, to the output of the fourth changeover switch (u4) of the preceding cell, and to the output of the additional constant multiplier (mn), and an additional inverter (ivn) having its input connected to the sign output (sg) of the additional subtracter (sbn) ;

— the outputs of all inverters (iv, ivn) are connected to the associated stage input of the register (rg) according to their weights, and the parallel output of the register (rg) is coupled to one of the inputs of the multiple-input adder (ma), and

— the output of the multiple-input adder (ma) provides the digital phase-detected signal (dp) of the first half-quadrant of the coordinate system.

**Revendications**

1. Démodulateur de phase numérique :
— avec un convertisseur analogique-numérique synchronisé par un signal de synchronisation en vue de la transformation du signal analogique à démoduler en un signal numérique, comportant un déphaseur numérique de 90°, auquel est amené le signal numérique pour la formation du signal en quadrature ;

— avec un circuit de conditionnement des signaux numériques et en quadrature, à la sortie duquel sont produits des signaux de quadrant x', y' correspondants appartenant au premier demi-quadrant du système de coordonnées x', y' ; et

— avec un circuit contenant une mémoire fixe qui fournit la fonction de tangente d'arc du quotient x'/y', caractérisé en ce que :

— le circuit est constitué par un additionneur multiple (ma), par un nième étage (sn) et par n-1 étages identiques (s1 à sn-1), où n = le nombre maximum de positions imposées pour un des signaux de quadrant (x', y'),

— lesdits étages étant eux-mêmes respectivement constitués par un additionneur (ad), un soustracteur (sb), un premier et un deuxième multiplicateurs à constante (m1, m2) pour le facteur $2^{-r}$, où r = 1 à n-1, par un premier, un deuxième et un troisième commutateurs électroniques (u1, u2, u3) et par une mémoire fixe (rm1) pour arctan $2^{-r}$, sur lesquels :

— au premier étage (s1), le premier signal de quadrant (x') et à chacun des autres étages (s2 à sn-1), la sortie du premier commutateur (u1) appartenant à l'étage qui précède, se trouve à la première entrée respective de l'additionneur (ad), du premier multiplicateur à constante (m1) et du premier commutateur (u1) de cet étage,

— au premier étage (s1), le deuxième signal de quadrant (y') et, à chacun des autres étages (s2 à sn-1), la sortie du deuxième commutateur (u2) appartenant à l'étage qui précède se trouve à l'entrée du deuxième multiplicateur à constante (m2) de cet étage et à la première entrée du deuxième commutateur (u2) ainsi qu'à l'entrée diminuende (m) du soustracteur (sb),

— la sortie du deuxième multiplicateur à constante (m2) se trouve à la deuxième entrée de l'additionneur (ad) et la sortie du premier multiplicateur à constante (m1) à l'entrée de soustraction (s) du soustracteur (sb),

— la sortie de l'additionneur (ad) se trouve à la deuxième entrée du premier commutateur (u1) et la sortie du soustracteur (sb) à la deuxième entrée du deuxième commutateur (u2),

— la première entrée du troisième commutateur (u3) se trouve à la sortie du nombre zéro (« 0 ») et sa deuxième entrée à la sortie de la mémoire fixe (rm1) et sa sortie à une des n entrées de l'additionneur multiple (ma),

— la sortie de signe (sg) du soustracteur (sb) se trouve à l'entrée de commande respective des trois commutateurs (u1, u2, u3), et la coordination des commutations est choisie de telle sorte que pour un signe négatif c'est la première entrée respective qui est interconnectée avec la sortie correspondante et la deuxième entrée qui est interconnectée pour un signe positif,

— le nième étage est constitué par un autre multiplicateur à constante (mn) pour le facteur $2^{-n}$, dont l'entrée se trouve à la sortie du premier commutateur (u1) du (n-1) ième étage (sn-1), par un autre soustracteur (sbn) dont l'entrée diminuende (m) se trouve à la sortie du deuxième commutateur (u2) du (n-1) ième étage et dont l'entrée de soustraction (s) se trouve à la sortie de l'autre multiplicateur à constante (mn), en outre par un autre commutateur (un), à la première sortie duquel est amené le nombre zéro (« 0 ») et enfin par une mémoire fixe (rmn) pour arctan $2^{-n}$, dont la sortie est reliée à la deuxième entrée de l'autre commutateur (un), dont la sortie se trouve sur l'additionneur multiple (ma) et dont l'entrée de commande se trouve à la sortie de signe (sg) de l'autre soustracteur (sbn),

— le signal numérique à phase démodulée (dp) du premier demi-quadrant du système de coordonnées est à prélever à la sortie de l'additionneur multiple (ma).

2. Démodulateur de phase numérique comportant :
— un convertisseur analogique-numérique synchronisé par un signal de synchronisation pour la conversion du signal analogique en un signal numérique,

— un déphaseur numérique à 90°, auquel est amené le signal numérique pour la formation du signal en quadrature,

— un circuit de conditionnement des signaux numériques et en quadrature, à la sortie duquel sont produits des signaux de quadrant x', y', appartenant au premier demi-quadrant du système de coordonnées x', y',

— un circuit contenant une mémoire fixe qui fournit la fonction tangente-arc du quotient y'/x', caractérisé en ce que :

— le circuit est constitué par un additionneur multiple (ma), par un registre (rg) à (n-j) étages, par n-j-1 cellules identiques (sj + 1), par une (n-j)-ième cellule (zn) et par j étages identiques (s1 à sj), où n est le nombre maximum de positions imposées pour un des signaux de quadrant (x', y') et où j est un des nombres entre 4 et 8, lesquels étages sont respectivement constitués par :

— un additionneur (ad), un premier soustracteur (sb1), un premier et un deuxième multiplicateurs à constante (m1, m2) pour le facteur $2^{-r}$ où r = 1 à j, par un premier, un deuxième et un troisième commutateurs (u1, u2, u3), ainsi que par une mémoire fixe (rm1) pour arctan $2^{-r}$ et sur lesquels :

— au premier étage (s1), le premier signal de quadrant (x') et à chacun des autres étages (s2 à sj), la sortie du premier commutateur (u1) appartenant à l'étage qui précède se trouve à la première entrée respective de l'additionneur (ad), du premier multiplicateur à constante (m1) et du premier commutateur (u1) de cet étage,

— au premier étage (s1), le deuxième signal de quadrant (y') et, à chacun des autres étages (s2 à sj), la sortie du deuxième commutateur (u2) appartenant à l'étage qui précède se trouve à l'entrée du deuxième multiplicateur à constante (m2) de cet étage et à la première entrée du deuxième commutateur (u2) ainsi qu'à l'entrée diminuende (m) du soustracteur (sb),

— la sortie du deuxième multiplicateur à constante (m2) se trouve à la deuxième entrée de l'additionneur (ad) et la sortie du premier multiplicateur à constante (m1) à l'entrée de soustraction (s) du premier soustracteur (sb1),

— la sortie de l'additionneur (ad) se trouve à la deuxième entrée du premier commutateur (u1) et la sortie du premier soustracteur (sb1), à la deuxième entrée du deuxième commutateur (u2),

— la première entrée du troisième commutateur (u3) se trouve au nombre zéro (« 0 ») et sa deuxième entrée à la sortie de la mémoire fixe (rm1) ainsi que sa sortie à l'une des j + 1 entrées de l'additionneur multiple (ma),

— la sortie de signe (sg) du premier soustracteur (sb1) se trouve à l'entrée de commande respective des trois commutateurs (u1, u2, u3),

— les cellules (sj + 1) sont respectivement constituées par un troisième multiplicateur à constante (m3) pour le facteur $2^{-r}$, où r' = j + 1 à n-1 dont l'entrée se trouve à la sortie du premier commutateur (u1) du jième étage (sj), par un quatrième commutateur (u4) dont la première entrée se trouve sur la (j + 1) ième cellule, à la sortie du deuxième commutateur (u2) du jième étage (sj) et sur chacune des autres cellules, à la sortie du quatrième commutateur (u4) de la cellule qui précède, par un deuxième soustracteur (sb2) dont l'entrée diminuende (m) se trouve à la première entrée du quatrième commutateur (u4), dont l'entrée de soustraction (s) se trouve à la sortie du troisième multiplicateur à constante (m3), dont la sortie se trouve à la deuxième entrée du quatrième commutateur (u4) et dont la sortie de signe (sg) se trouve à l'entrée de commande du quatrième commutateur (u4), et par un inverseur (iv), dont l'entrée est reliée à la sortie de signe (sg) du quatrième commutateur (u4),

— avec un signe négatif à la sortie de signe (sg) des deux soustracteurs (sb1, sb2) et la première entrée de chacun des commutateurs (u1, u2, u3, u4) est interconnectée avec la sortie correspondante, alors que c'est leur deuxième entrée qui est interconnectée pour un signe positif,

— la (n-j) ième cellule (zn) est constituée par un autre multiplicateur à constante (mn) pour le facteur $2^{-n}$, dont l'entrée se trouve à la sortie du premier commutateur (u1) du jième étage (sj), par un autre soustracteur (sbn) dont l'entrée diminuende (m) se trouve à la sortie du quatrième commutateur (u4) de la cellule qui précède et dont l'entrée de soustraction (s) se trouve à la sortie de l'autre multiplicateur à constante (mn) et par un autre inverseur (in) dont l'entrée se trouve à la sortie du signe (sg) de l'autre soustracteur (sbn),

— la sortie respective de tous les inverseurs (iv, ivn) se trouve, en fonction de son poids, à l'entrée d'étage correspondante du registre (rg) et sa sortie parallèle à une des entrées de l'additionneur multiple (ma), et

— le signal numérique à phase démodulée (dp) du premier demi-quadrant du système de coordonnées est à prélever à la sortie de l'additionneur multiple (ma).

FIG. 1

FIG. 2